Europäisches Patentamt

(19) European Patent Office

Office européen des brevets

(11) Numéro de publication: **0 068 947**
**B1**

(12) # FASCICULE DE BREVET EUROPEEN

(45) Date de publication du fascicule du brevet:
11.09.85

(21) Numéro de dépôt: 82401040.9

(22) Date de dépôt: 08.06.82

(51) Int. Cl.⁴: **H 01 L 27/14, H 01 L 29/78**

(54) **Ensemble détecteur photonique, lecteur à transfert de charges adapté, et cible de prise de vues utilisant un tel ensemble.**

(30) Priorité: 23.06.81 FR 8112296

(43) Date de publication de la demande:
05.01.83 Bulletin 83/1

(45) Mention de la délivrance du brevet:
11.09.85 Bulletin 85/37

(84) Etats contractants désignés:
DE GB NL

(56) Documents cités:
EP - A - 0 029 351
US - A - 4 087 833
US - A - 4 112 316
US - A - 4 150 304

IEEE JOURNAL OF SOLID-STATE CIRCUITS, vol.SC-14, no.3, juin 1979, New York (US) R. KOCH: "Charge-Injection device with CCD readout", pages 604-608
IEEE JOURNAL OF SOLID-STATE CIRCUITS, vol.SC-13, no.1, février 1978, New York (US) J.T. LONGO et al.: "Infrared focal planes in intrinsic semiconductors", pages 139-158
IEEE TRANSACTIONS ON ELECTRON DEVICES, vol.ED-27, no.1, janvier 1980, New York (US) P. FELIX et al.: "CCD readout of infrared hybrid focal-plane arrays", pages 175-188

(73) Titulaire: THOMSON-CSF, 173, Boulevard Haussmann, F-75379 Paris Cedex 08 (FR)

(72) Inventeur: Arques, Marc, THOMSON-CSF SCPI 173, bld Haussmann, F-75379 Paris Cedex 08 (FR)

(74) Mandataire: Mayeux, Michèle et al, THOMSON-CSF SCPI 173, Bld Haussmann, F-75379 Paris Cedex 08 (FR)

Il est rappelé que: Dans un délai de neuf mois à compter de la date de publication de la mention de la délivrance du brevet euro-péen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un ensemble formé par un détecteur de rayonnement et son système de lecture à transfert de charges.

Un tel ensemble est utilisé à l'élaboration d'images de rayonnements incidents, infrarouge notamment.

L'invention concerne en particulier le cas où les détecteurs, ou capteurs, et les lecteurs, réalisés à l'état solide, consistent en des diodes photovoltaïques ou photodiodes, d'une part et, d'autre part, en des lecteurs à transfert de charges (DTC) — CCD dans la littérature de langue anglaise-aujourd'hui bien connus, dans lesquels le signal à lire est transféré de proche en proche vers le registre de lecture. Ce signal est ici celui des charges libres engendrées dans la diode par le rayonnement reçu. L'invention sera décrite à titre non limitatif, dans le cas de telles diodes.

Un tel transfert s'accompagne toujours d'une certaine dégradation du signal. L'expérience montre que celle-ci se produit principalement à la jonction entre le dispositif de transfert de charges et le capteur. Elle a pour cause une injection défectueuse du signal de la photodiode dans le lecteur, liée aux valeurs relatives des impédances de la photodiode et de l'élément dans lequel est injecté son signal, à savoir le transistor de liaison entre photodiode et lecteur. Elle s'observe quel que soit le solide utilisé à la réalisation des diodes, tellurure d'étain plomb (Pb, Sn, Te) ou de cadmium mercure (Hg Cd Te) et celui utilisé au transfert de charges, couramment le silicium de type n ou p.

La difficulté est bien connue de l'homme de l'art; elle ressort de la formule du rendement d'injection r qui peut s'écrire:

$$r = \frac{g_m R_D}{1 + g_m R_D}$$

et qui n'est autre que celle de la répartition des courants dans un ensemble de deux résistances alimentées en parallèle à courant constant, ici l'impédance $R_D$ de la photodiode, et $\frac{1}{g_m}$ , impédance du transistor, en désignant par le terme $g_m$, adopté dans ce qui suit, sa transconductance.

La résistance $R_D$ n'est guère modifiable; elle est pratiquement fixée par l'état actuel de la technologie de réalisation des photodiodes dans les matériaux citée.

Quant au terme $g_m$, on peut considérer qu'il est convenablement représenté, dans les conditions habituelles, avec des transistors à faible inversion, par

$$g_m = \frac{q I_s}{kT} \qquad (1)$$

où q, k, et T sont la charge de l'électron, la constante de Boltzman et la température abso

lue, et où $I_s$ représente le courant total de signal mis en jeu dans l'injection, courant qui comprend une composante alternative $i_s$ correspondant aux variations du signal lors des lectures successives.

Pour augmenter le rendement r, qui croît avec le produit $g_m R_D$, et donc, à $R_D$ pratiquement fixe, avec $g_m$, on ne dispose, à température de fonctionnement donnée, que de $I_s$.

On a déjà proposé des dispositions permettant d'augmenter ce courant, qui est fixé par le point de fonctionnement de la diode, en lui adjoignant un courant supplémentaire, voir: Topics in Applied Physics, vol. 38, p. 78 — Charge Coupled Devices — Editor D.F. Barbe Springer Verlag Berlin, Heidelberg, New-York.

L'invention a pour objet un moyen nouveau d'augmentation du courant $I_s$, dans les conditions qui vont être précisées.

L'invention concerne un ensemble détecteur photonique, lecteur à transfert de charges comportant au moins un détecteur photonique exposé au rayonnement incident et un lecteur des signaux de ce détecteur, reliés entre eux par une transition consistant en un transistor à effet de champ (MOS) et une grille de transfert, transition par laquelle les signaux sont transmis du détecteur au lecteur par commutation séquentielle des potentiels des électrodes du transistor, caractérisé en ce qu'il comprend, sur le substrat du transistor, au voisinage de la source de celui-ci, une électrode supplémentaire sous laquelle est accumulée au moment de la mise en fonctionnement de l'ensemble, à l'aide des signaux du détecteur, une charge de réserve fixe, et en ce que, le potentiel appliqué à cette électrode supplémentaire au cours du cycle de commutation est un potentiel décroissant régulièrement dans le temps.

L'invention sera mieux comprise en se reportant à la description qui suit et aux figures jointes, qui représentent:

figure 1: le schéma électrique équivalent d'une photodiode et de son système d'injection dans le lecteur;

figure 2; une représentation schématique, selon l'art connu, de l'ensemble précédent;

figure 3, le même ensemble modifié selon l'invention;

figure 4, un diagramme explicatif du fonctionnement de l'ensemble précédent;

figure 5, le diagramme des temps correspondant.

figure 6, un diagramme relatif à une variante de l'invention.

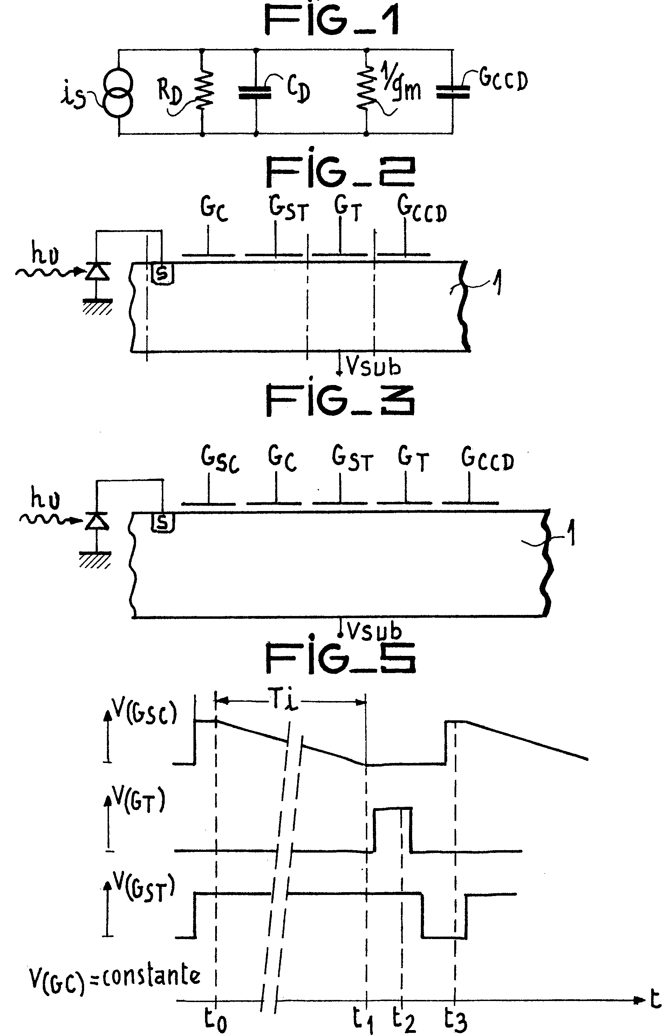

La figure 1 donne le schéma équivalent de l'ensemble photodiode, système d'injection. Sur ce schéma, sont représentées les quantités $R_D$ et $g_m$ dont il a été question ainsi que les parties capacitives $C_D$ et $C_{CCD}$, respectivement de la photodiode et du système d'injection. En basse fréquence, dans les conditions de fonctionnement, la répartition du courant entre les deux parties est régie par la formule du rendement r donnée plus haut, où ces capacités n'interviennent pratiquement pas.

Dans ce qui suit, on adoptera la terminologie et la représentation habituelles en matière de transfert de charges, utilisant la notion de »puis de potentiel«, la profondeur de ces puits sous chaque électrode étant proportionnelle au potentiel de surface sous l'électrode. On pourra consulter pour ces données générales l'article de M.F. Tompsett sous les références »Charge Transfer Devices« J.Vac. Sci. Technol; vol 9, N° 4, July-August 1972 Pages 1166 à 1181 et celui de W.S. Boyle et G.E. Smitt sous les références »Charge Coupled Semiconductor Devices« The Bell System Technical Journal, April 1970 pages 587 à 593.

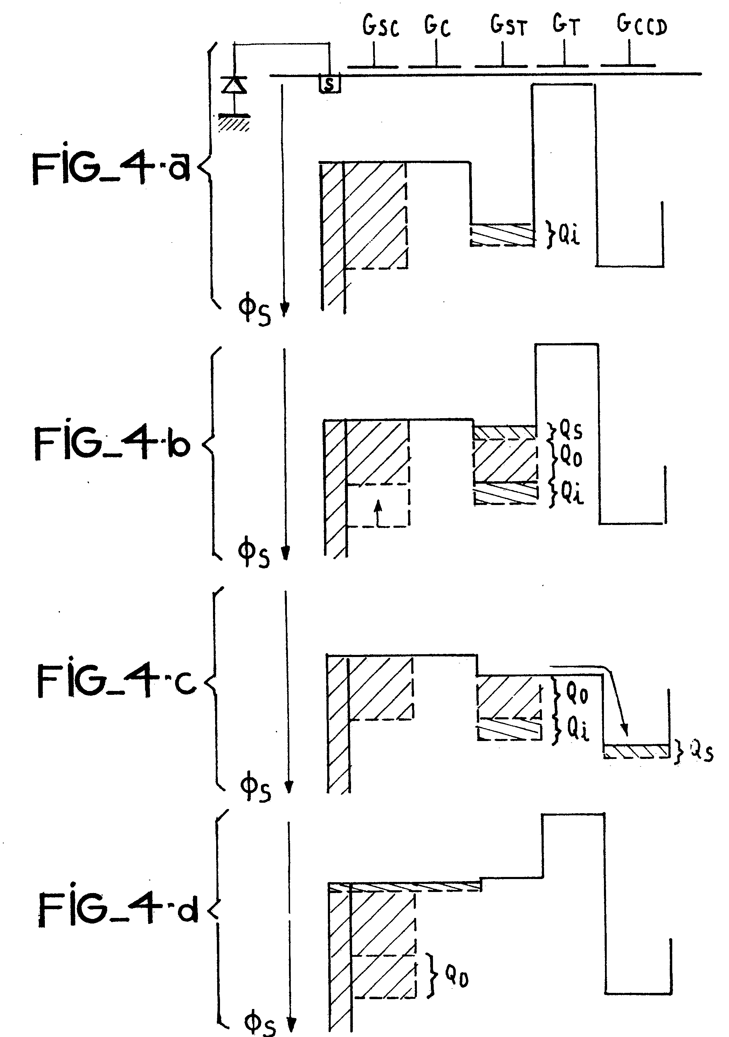

Ceci étant, on indique, schématiquement sur la figure 2, comment se présente en général et selon l'art connu, la transition entre un détecteur et son lecteur. Le détecteur est sur la figure une diode photovoltaïque représentée de la façon conventionnelle, sans repère. Cette diode reçoit le rayonnement photonique $h\nu$ sous l'effet duquel elle engendre un signal électrique, elle est réalisée dans un substrat choisi pour sa sensibilité au rayonnement incident, en l'un des matériaux cités dans l'introduction, par exemple. La transition consiste en un transistor à effet de champ MOS. Le repère S désigne l'électrode de source du transistor MOS, réalisée par exemple par une diffusion dans un substrat 1 de type opposé, préférentiellement une diffusion de type N dans un substrat, en silicium par exemple, de type P. Les autres électrodes du transistor sont représentées en $G_C$ et $G_{ST}$ désignant respectivement la grille de commande de ce transistor et, en quelque sorte, son drain, drain sous lequel a lieu le stockage des charges de signal avant leur injection dans le dispositif à transfert de charges, dont d'entrée est la grille marquée $G_{CCD}$ précédée par une grille de transfert marquée $G_T$.

Sur la figure, la transition occupe, comme on le voit, la partie comprise entre les deux traits mixtes extrêmes; elle est composée du transistor MOS compris entre les deux premiers traits mixtes et de la grille de transfert $G_T$, situés entre la photodiode, à gauche et le lecteur à CCD, à droite. C'est dans cette partie qu'intervient le rendement r considéré plus haut.

Les moyens de connexion entre le substrat dans lequel est réalisée la photodiode et celui, figuré avec le repère 1 sur la figure, qui relèvent de l'art connu, n'ont pas été représentés. La même lettre S est utilisée également, en indice, pour désigner le courant mis en jeu dans l'opération d'injection du signal de la photodiode dans le lecteur à transfert de charges.

La figure 3, reproduit le schéma précédent tel que modifié par l'invention. Une grille supplémentaire portant le repère $G_{SC}$ est appliquée sur le substrat 1; dans l'exemple, elle est disposée entre la source S et la grille de commande $G_C$. Son rôle est la création du courant supplémentaire dont il a été question qui, ajouté au courant de signal, améliore le rendement d'injection; il sera précisé ci-dessous à l'aide des figures 4 (a, b, c, d).

C'est à cause de ce rôle, au cours duquel elle agit comme une source de courant, qu'on lui a affecté l'indice SC.

Les figures 4, représentent les états successifs des puits de potentiel et les charges contenues dans ces puits au cours d'un cycle d'injection du signal d'un détecteur dans le lecteur correspondant. Le transfert des charges s'y opère comme dans un dispositif à transfert de charges, comme il va être indiqué.

Sur ces figures, les puits de potentiel sont représentés, selon l'usage, par des échelons suivant l'axe des potentiels, orienté positivement vers le bas. Des pointillés sont utilisés pour montrer ce que serait le potentiel de ces puits en l'absence de charges; la présence de charges est indiquée par des hachures; $\Phi_S$ est le potentiel de surface sous l'électrode considérée.

Au début du cycle, c'est-à-dire au temps $t = t_0$, l'état de la transition est celui de la figure 4(a).

La colonne étroite couverte de hachures à gauche de la figure représente la quantité de charges présente dans la diode de source S, maintenue constamment, comme on le voit, au niveau haut du potentiel du puits sous la grille $G_C$. Les charges du signal injectées dans cette diode la traversent pour gagner le puits de potentiel sous $G_{SC}$. Une petite quantité de charges, notée $Q_i$ est présente dans le puits de la grille de stockage $G_{ST}$. On reviendra sur cette quantité $Q_i$ plus loin.

Pendant la période d'intégration $T_i$ qui suit, on applique à la grille $G_{SC}$ de l'ensemble de l'invention une rampe de tension, c'est-à-dire une tension qui décroît régulièrement dans le temps, suivant une loi linéaire éventuellement. La tension $G_{SC}$ diminuant (flèche de la figure 4(b)), le puits sous cette électrode se vide partiellement des charges qu'il contient, charges qui se déplacent, sous $G_C$, vers l'électrode de stockage $G_{ST}$. Un courant supplémentaire $I_0$ est créé par l'écoulement de ces charges, désignées par $Q_0$ sur la figure, courant qui s'ajoute au courant de signal $I_S$ dans l'expression (1) de la transconductance $G_m$, qui se trouve de ce fait augmentée, et éventuellement de façon sensible; la quantité $Q_0$ peut être de l'ordre de la quantité de charges $Q_S$ du signal, ou plusieurs fois supérieure à cette dernière. On notera que, dans le cas de la loi linéaire, le courant additionnel est pratiquement constant pendant toute la période d'intégration, car la capacité sous la grille $G_{SC}$ reste constante pendant cette période, du fait que le potentiel de surface sous cette grille est fixé par le potentiel de la grille $G_C$, qui est maintenu constant pendant tout le cycle, comme le montrent les diagrammes des figures 4.

A la fin de la période d'intégration $T_i$, la situation est celle de la figure 4(b), où, sous la grille de stockage $G_{ST}$, sont représentées les charges $Q_i$, $Q_S$ et $Q_0$.

Au temps $t_2$, peu après la fin de la période d'intégration, la charge $Q_S$ est transférée sous la grille $G_T$, dont le potentiel est augmenté à cette fin, vers la grille d'entrée $G_{CCD}$ (flèche) du dispositif à transfert de charges, figure 4(c). Au cours de cette phase, le potentiel haut de $G_T$ est tel que la charge $Q_S$, et elle seule, soit transférée sous $G_{CCD}$, à l'exclusion de toute fraction de la charge $Q_0$, la charge $Q_i$ étant telle que la somme des charges $Q_0 + Q_i$ remplisse alors exactement le puits de stockage sous $G_{ST}$. On bloque ensuite le canal sous $G_T$ puis on diminue le potentiel sous $G_{ST}$ et on redonne au potentiel de $G_{SC}$ la valeur qu'il avait au sommet de la rampe de tension, au temps $t_0$. Ceci a pour effet de ramener la charge $Q_0$ sous l'électrode $G_{SC}$; la situation est celle de la figure 4(d), au temps $t_3$. La charge $Q_i$ est alors répartie sous les électrodes $G_{SC}$, $G_C$ et éventuellement $G_{ST}$; elle est représentée sur la figure 4(d) par le petit rectangle horizontal couvert de hachures sérrées. Enfin, on élève le potentiel de $G_{ST}$ pour revenir aux conditions de l'instant initial $t_0$, avant le cycle suivant et ainsi de suite.

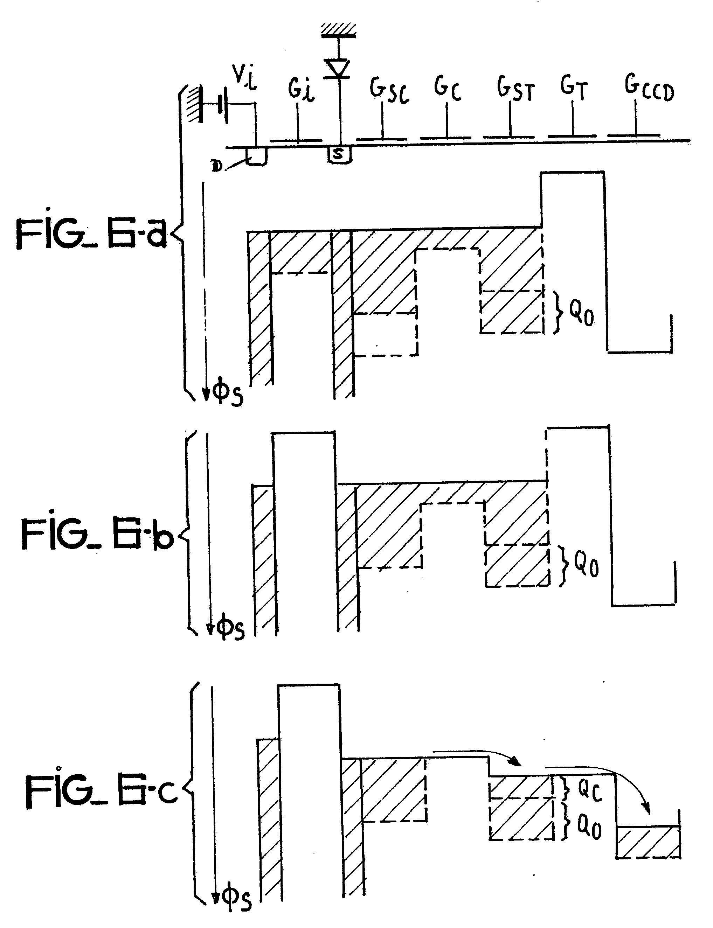

On donne, pour fixer les idées, sur la figure 5, un exemple de diagramme des temps correspondant au cycle décrit. Sur cette figure les axes des tension V sont orientés, cette fois, positivement vers le haut; le diagramme est fait à tension de grille de commande $V_{GC}$ constant. On a coupé l'axe des temps pour respecter les proportions entre le temps d'intégration marqué $T_i$ et la durée de la fin du cycle, entre $t_1$ et $t_3$, qui est une faible fraction de la période $T_i$, de l'ordre du dixième au centième.

L'invention utilise, comme on l'a dit, une quantité de charges $Q_0$ supplémentaire pour améliorer l'injection dans le dispositif à transfert de charges. En même temps, il a été question d'une autre quantité $Q_i$ dont l'utilité n'a pas été jusqu'ici mise en évidence. En fait, dans le cas où le dispositif ne comprend qu'un seul détecteur, c'est-à-dire une photodiode unique et un seul lecteur, une telle charge $Q_i$ n'est pas nécessaire. Il en va autrement lorsque sont mises en œuvre plusieurs photodiodes et leurs lecteurs, comme dans les dispositifs de prises de vue, où elles sont en grand nombre et disposées suivant une mosaïque dans le substrat détecteur ou sur quelques barrettes seulement, comme on sait que cela peut être le cas dans l'état actuel de la technologie des cibles. En général les transitions sont alors commandées toutes à la fois, ou par groupes, par des tensions communes appliquées à leurs électrodes; c'est le cas notamment pour les grille $G_T$ mais, comme les potentiels de seuil de ces grilles ne sont pas tous les mêmes, pour une tension appliquée donnée, leurs potentiels de surface sont différents, et le transfert exact des seules quantités $Q_S$ selon la figure 4(c) ne se trouve pas assuré pour toutes les transitions. C'est pour remédier à cet état de choses que l'invention prévoit d'introduire une charge initiale, la charge $Q_i$ en question, sous les éléments de stockage $G_{ST}$ de chaque ensemble détecteur, lecteur, d'une valeur propre à chacun d'eux.

Dans tous les cas, la quantité de charge $Q_i$ est obtenue à partir des charges de signal de la photodiode, accumulées sous $G_{SC}$ et $G_{ST}$ dans une phase préliminaire, au cours de laquelle on maintient la photodiode exposée au rayonnement sans procéder au transfert de ses signaux vers le lecteur. La charge $Q_i$ est généralement faible, de l'ordre de $Q_S$ ou un peu supérieur, comme représenté.

On procède de même pour la quantité $Q_0$, sensiblement supérieure aux précédentes. Cette charge est la même pour tous les ensembles détecteurs, lecteurs.

Dans une variante de l'invention, une diode supplémentaire D est formée dans le substrat 1, associée à une grille $G_i$ et reliée à une source de tension, $V_i$, comme le montre le dessin de la figure 6. La grille $G_i$ occupe une position adjacente à l'une des sources S des figures précédentes (ou plusieurs d'entre elles). Cette disposition assure la protection de la photodiode contre des surtensions éventuelles au moment de la mise en fonctionnement.

La compensation s'opère comme suit d'après le diagramme des figures 6(a), 6(b), 6(c).

Dans un premier temps, les potentiels appliqués sur $G_{SC}$ et $G_T$ sont au niveau bas, le potentiel appliqué sur $G_{ST}$ étant au niveau haut. On impose le potentiel $V_i$ comme potentiel de surface sous $G_i$, $G_{SC}$, $G_C$, $G_{ST}$ et S, en appliquant une tension élevée sur $G_i$ (figure 6(a)).

Dans un deuxième temps, on isole S, $G_{SC}$, $G_C$ et $G_{ST}$ de la tension $V_i$ en appliquant une tension faible sur $G_i$ (figure 6(b)).

Dans un troisième temps, on applique la tension haute sur $G_T$. Cette tension doit être telle que le puits de stockage sous $G_{ST}$ puisse alors contenir une charge supérieure à $Q_0$. Une partie des charges est évacuée sous le CCD (flèches). Nous obtenons alors la situation de la figure 6(c). La situation sous S, $G_{SC}$, $G_C$, $G_{ST}$ et $G_T$ est la même que sur la figure 4(c). On dispose sous $G_{ST}$ de la charge $Q_0 + Q_i$. Les conditions normales de fonctionnement sont réalisées.

Il est possible également, dans une autre variante au schéma de la figure 3, d'ajouter une grille supplémentaire entre la source S et la grille $G_{SC}$, qui permette d'isoler la diode S du reste de la transition pendant que s'effectue le retour de la charge $Q_0$ de l'électrode de stockage $G_{ST}$ vers l'électrode $G_{SC}$, entre les instants $t_2$ et $t_3$.

On remarquera enfin que l'invention, décrite dans le cas d'une grille $G_{SC}$ placée entre la source S et l'électrode de controle $G_C$, est en tous points transposable au cas où la grille $G_{SC}$ serait située du côté opposé à $G_C$ par rapport à cette source; dans ce cas, les charges accumulées sous $G_{SC}$ suivraient sans difficultés le même cheminement sous les différentes grilles après avoir franchi le potentiel constant sous S.

Pour la clarté, les grilles ont été représentées sur les dessins coplanaires et sans recouvrement les unes par rapport aux autres. Un tel recouvrement peut s'avérer nécessaire dans la pratique; elles pourraient aussi ne pas être coplanaires.

La structure de l'invention est de réalisation facile, l'intégration dans le substrat de la grille supplémentaire $G_{SC}$ ne posant aucun problème dans l'état actuel de la technologie. Le rôle de source de courant qu'elle joue évite l'apport de charges extérieures pour la création du courant supplémentaire. Les variations de tension de seuil de la grille de transfert $G_T$ est sans influence sur cette source.

L'invention trouve une application dans la réalisation des cibles de prise de vues en infrarouge.

## Revendications

1. Ensemble détecteur photonique, lecteur à transfert de charges comportant au moins un détecteur photonique exposé au rayonnement incident et un lecteur ($G_{CCD}$) des signaux de ce détecteur, reliés entre eux par une transition consistant en un transistor à effet de champ (MOS) (S, $G_C$, $G_{ST}$) et une grille de transfert ($G_T$), transition par laquelle les signaux sont transmis du détecteur au lecteur par commutation séquentielle des potentiels des électrodes du transistor, caractérisé en ce qu'il comprend, sur le substrat (1) du transistor, au voisinage de la source (S) de celui-ci, une électrode supplémentaire ($G_{SC}$), sous laquelle est accumulée au moment de la mise en fonctionnement de l'ensemble, à l'aide des signaux du détecteur, une charge de réserve fixe ($Q_0$), et en ce que, le potentiel appliqué à cette électrode supplémentaire au cours du cycle de commutation est un potentiel décroissant régulièrement dans le temps.

2. Ensemble suivant la revendication 1 comprenant au moins deux détecteurs, et deux transistors dont les électrodes sont commandées par les mêmes potentiels, caractérisé en ce qu'il comprend en outre des moyens pour accumuler sous l'électrode ($G_{ST}$) de chaque transition, au moment de la mise en fonctionnement de l'ensemble, une autre quantité de charges ($Q_i$) compensant l'inégalité des potentiels régnant dans le substrat (1) sous les différentes grilles ($G_T$) portées au même potentiel.

3. Ensemble suivant l'une des revendications 1 ou 2, caractérisé en ce que les moyens d'accumulation des charges $Q_0$ et $Q_i$ comprennent une diode (D) formée dans le substrat (1) au voisinage de la souce (S), une grille ($G_i$) appliquée sur ce substrat, adjacente à l'une des électrodes (S), ($G_{SC}$), ($G_C$) ou ($G_{ST}$), et des moyens pour appliquer une différence de potentiel à la diode (D) par rapport au substrat.

4. Ensemble suivant l'une des revendications 1, 2 ou 3, caractérisé en ce que les détecteurs sont des diodes photovoltaïques.

5. Ensemble suivant la revendication 1, caractérisé en ce que le potentiel appliqué à cette electrode supplémentaire décroît linéairement dans le temps.

6. Cible de prise de vues caractérisée en ce qu'elle comporte au moins un ensemble suivant l'une des revendications 1 à 5.

## Patentansprüche

1. Lichtdetektor- und Ladungstransferleseeinheit, mit mindestens einem der anfallenden Strahlung ausgesetzten Photonendetektor und einem die Signale dieses Detektors empfangenden Leser ($G_{CCD}$), die miteinander durch einen aus einem MOS-FET (S, $G_C$, $G_{ST}$) und einem Transfergitter ($G_T$) bestehenden Übergang verbunden sind, durch die die Signale vom Detektor zum Leser mithilfe einer sequentiellen Schaltung der Elektrodenpotentiale des Transistors übertragen werden, dadurch gekennzeichnet, daß sich auf dem Transistorsubstrat (1) in der Nähe der Quelle (S) des Transistors eine weitere Elektrode ($G_{SC}$) befindet, unter der im Augenblick der Inbetriebsetzung der Einheit mithilfe der Detektorsignale eine feste Reserveladung ($Q_0$) angesammelt wird, und daß das an diese weitere Elektrode während des Schaltzyklus angelegte Potential ein zeitlich regelmäßig abnehmbares Potential ist.

2. Einheit nach Anspruch 1 mit mindestens zwei Detektoren und zwei Transistoren, deren Elektroden von denselben Potentialen gesteuert werden, dadurch gekennzeichnet, daß sie außerdem Mittel aufweist, um im Augenblick der Inbetriebsetzung der Einheit unter der Elektrode ($G_{ST}$) jedes Übergangs eine andere Menge von Ladungen ($Q_i$) anzusammeln, durch die die Potentialungleichheiten, die in dem Substrat (1) unter den verschiedenen auf dasselbe Potential gebrachten Gittern ($G_T$) herrschen, kompensiert werden.

3. Einheit nach einem der Ansprüche 1 oder 2, dadurch gekennzeichnet, daß die Mittel zur Ansammlung der Ladungen $Q_0$ und $Q_i$ eine Diode (D), die in dem Substrat (1) in der Nähe der Quelle (S) gebildet ist, ein auf dieses Substrat in der Nähe der Elektroden (S), ($G_{SC}$), ($G_C$) oder ($G_{ST}$) aufgebrachtes Gitter ($G_i$) und Mittel enthalten, um eine Potentialdifferenz bezüglich des Substrats an die Diode (D) anzulegen.

4. Einheit nach einem der Ansprüche 1, 2 oder 3, dadurch gekennzeichnet, daß die Detektoren als photovoltaische Dioden ausgebildet sind.

5. Einheit nach Anspruch 1, dadurch gekennzeichnet, daß das an diese weitere Elektrode angelegte Potential zeitlich linear abnimmt.

6. Bildaufnahmegerät, dadurch gekennzeichnet, daß es mindestens eine Einheit nach den Ansprüchen 1 bis 5 enthält.

## Claims

1. A photonic detector-charge transfer reader assembly comprising at least one photonic detector exposed to the incident radiation and a reader ($G_{CCD}$) for reading the signals from this detector, connected together by a transition consisting of a MOS-field effect transistor (S, $G_C$, $G_{ST}$) and a transfer grid ($G_T$), by which transition the signals are transmitted form the detector to the reader by sequential switching of the potentials of the electrodes of the transistor, characterized in that there is further provided on the substrate (1) of the transistor, in the vincinity of the source (S) thereof, an additional electrode ($G_{SC}$) under which a defined reserve charge ($Q_0$) is accumulated at the time when the assembly is brought into operation, by means of the signals from the detector, and that the potential applied to this additional electrode during the switching cycle is a steadily decreasing potential in time.

2. An assembly as claimed in claim 1, comprising at least two detectors and two transistors whose electrodes are controlled by the same potentials, chaacterized in that there are further provided means for accumulating another charge quantity ($Q_i$) under the electrode ($G_{ST}$) of each transition, at the time when the assembly is brought into operation, this quantity compensating for the inequality of the potentials reigning in the substrate (1) under the different grids brought to the same potential.

3. An assembly as claimed in one of claims 1 or 2, characterized in that said means for accumulating the charges $Q_0$ and $Q_i$ comprise a diode (D) formed in the substrate (1) in the vicinity of said source (S), a grid ($G_i$) applied on this substrate adjacent one of said electrodes (S), ($G_{SC}$), ($G_C$) or ($G_{ST}$), and means for applying a potential difference to said diode (D) with respect to said substrate.

4. An assembly as claimed in one of claims 1, 2 or 3, characterized in that said detectors are photovoltaic diodes.

5. An assembly as claimed in claim 1, characterized in that the potential applied to said additional electrode decreases linearily in time.

6. An image forming target, characterized in that it comprises at least one assembly such as claimed in one of claims 1 to 5.

# FIG_1

$i_S$  $R_D$  $C_D$  $1/g_m$  $G_{CCD}$

# FIG_2

$G_C$  $G_{ST}$  $G_T$  $G_{CCD}$

$h\upsilon$  S  1

$V_{sub}$

# FIG_3

$G_{SC}$  $G_C$  $G_{ST}$  $G_T$  $G_{CCD}$

$h\upsilon$  S  1

$V_{sub}$

# FIG_5

$V(G_{SC})$  $T_i$

$V(G_T)$

$V(G_{ST})$

$V(G_C) = constante$

$t_0$  $t_1$  $t_2$  $t_3$  $t$

FIG_4·a

FIG_4·b

FIG_4·c

FIG_4·d

FIG. 6-a

FIG. 6-b

FIG. 6-c